Europäisches Patentamt

European Patent Office

Office européen des brevets

(11) Numéro de publication : **0 506 526 A1**

# (12) DEMANDE DE BREVET EUROPEEN

(21) Numéro de dépôt : **92400751.1**

(51) Int. Cl.⁵ : **H01L 23/538**

(22) Date de dépôt : **20.03.92**

(30) Priorité : **26.03.91 FR 9103622**

(43) Date de publication de la demande :
**30.09.92 Bulletin 92/40**

(84) Etats contractants désignés :
**DE GB IT**

(71) Demandeur : **THOMSON-CSF
51, Esplanade du Général de Gaulle
F-92800 Puteaux (FR)**

(72) Inventeur : **Bureau, Jean-Marc
THOMSON-CSF, SCPI, Cédex 67
F-92045 Paris la Défense (FR)**
Inventeur : **Graciet, Michel
THOMSON-CSF, SCPI, Cédex 67
F-92045 Paris la Défense (FR)**
Inventeur : **Bernard, François
THOMSON-CSF, SCPI, Cédex 67
F-92045 Paris la Défense (FR)**

(74) Mandataire : **Guérin, Michel et al
THOMSON-CSF SCPI
F-92045 PARIS LA DEFENSE CEDEX 67 (FR)**

(54) **Module hybride et procédé de réalisation.**

(57)     L'invention concerne un module hybride de constitution nouvelle et un procédé de réalisation de ce module hybride, dans lequel un film plan tendu de polymère est fixé sur les faces actives de plusieurs puces juxtaposées, les interconnexions entre puces étant ensuite réalisées par dépôt conducteur sur la surface du film et contact avec les puces à travers le film.

FIG.3

EP 0 506 526 A1

La présente invention concerne les systèmes hybrides d'assemblage et d'interconnexion d'une pluralité de puces de circuits intégrés sur un même substrat. Plus précisément elle concerne un nouveau procédé de réalisation de module hybride, procédé grâce auquel les différentes interconnexions sont facilitées. L'invention concerne aussi un module hybride de constitution originale.

A l'heure actuelle, la densité, le nombre d'entrées/sorties à connecter et les performances en vitesse des circuits intégrés modernes étant en accroissement constant, les techniques classiques d'assemblage et d'interconnexions de ces circuits sont insuffisantes

Généralement, les circuits sont collés sur un substrat qui comporte déjà un réseau d'interconnexion. Ce substrat est souvent un substrat de céramique multicouche. Parfois même cela peut être un substrat de silicium sur lequel on a formé par microlithographie un réseau d'interconnexion de haute densité. Ces circuits peuvent alors être connectés au substrat selon différentes techniques qui peuvent être les suivantes :

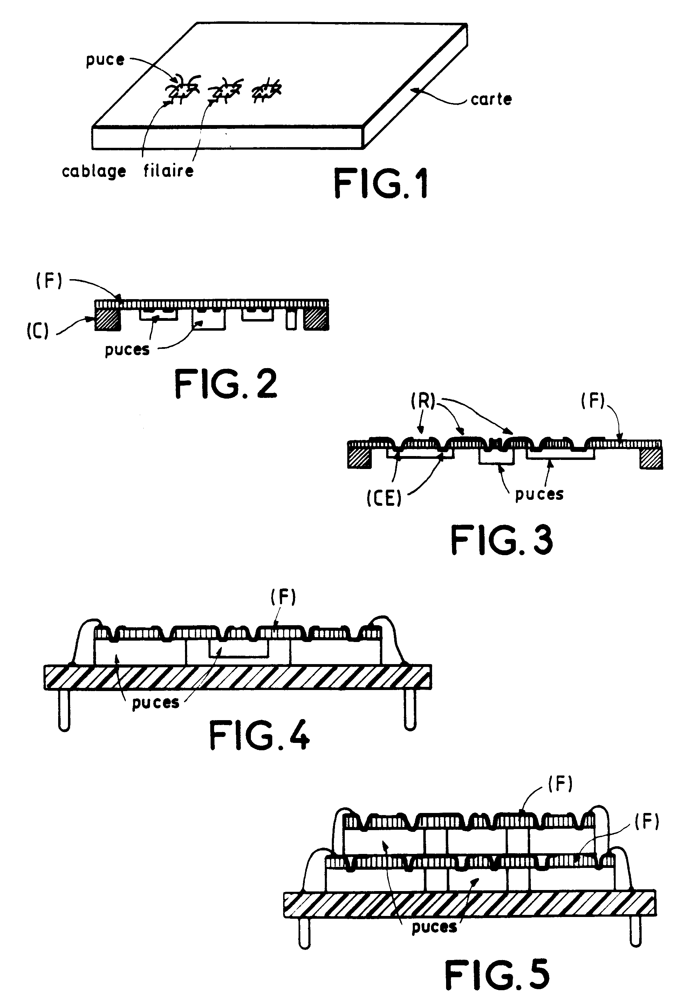

– le câblage filaire, permettant d'utiliser des puces standard, qui utilise une machine venant souder fil à fil les plots de la puce aux plots du réseau d'interconnexion (figure 1).

– des procédés utilisant des puces connectées préalablement à des rubans (TAB) ou des puces avec plots de soudure à retourner pour souder sur une carte. Ces procédés collectifs restent très onéreux et ne permettent pas d'augmenter vraiment la densité des connexions. En effet quelle que soit l'une des techniques précédemment citées, la taille des connexions ne peut descendre en dessous d'une dizaine de microns, alors que la résolution des circuits élémentaires est voisine du micron.

De plus, la présence de fils ou de soudures entraîne dans les circuits des impédances mal contrôlées et notamment lorsque l'on augmente la fréquence.

Parallèlement à ces techniques, la technique d'intégration sur tranche entière de silicium par exemple, permet de former plusieurs circuits intégrés simultanément sur le même substrat, que l'on connecte ensuite par des techniques classiques de microlithographie sur substrat parfaitement plan. Cette technique très séduisante n'offre cependant actuellement que de mauvais rendements, dans la mesure où l'on connecte toutes les puces, qu'elles soient bonnes ou mauvaises (dans les techniques précédentes, après test, seules les puces valables sont connectées) et ne permet la fabrication que de circuits de nature identique (tous les circuits sont en silicium).

Dans ce contexte, la présente invention propose un nouveau procédé de réalisation de modules hybrides, dans lequel un film plan tendu de polymère de bonne tenue mécanique est fixé sur les faces actives de plusieurs puces juxtaposées, après quoi des interconnexions entre puces sont réalisées par gravure du film de façon à dégager les plots des puces, cette gravure étant suivie d'un dépôt conducteur sur la surface du film et sur les flancs des ouvertures réalisées par gravure. Par l'expression face active, on entend une face qui porte des plots de contact par les lesquels la puce peut être reliée à l'extérieur.

Les ouvertures formées dans le film, pour permettre l'accès à des zones de contact sur la puce sont de préférence formées par photogravure du film après fixation du film sur les puces juxtaposées. Les interconnexions sont formées de préférence par dépôt métallique et photogravure.

De préférence, le film est tendu sur un cadre rigide plan avant d'être fixé sur les puces. Ensuite, l'ensemble pures + film peut être fixé sur un substrat rigide plan, le cadre plan étant éliminé. Des connexions classiques par exemple par fils soudés, peuvent alors être prévues entre des zones conductrices formées sur le film et des zones conductrices de substrat reliées à des broches de connexion externes. On peut d'ailleurs prévoir d'empiler sur le même substrat plusieurs ensembles film + puces réalisés séparément (montage dit "à trois dimensions").

La fixation entre le film et les pouces peut s'effectuer par adhérence directe si le film est naturellement adhésif (éventuellement en présence de chaleur et de pression suffisante), ou encore avec interposition d'une colle.

Le polymère employé est de préférence un polymère thermostable de type polyimide ou polyquinoxaline pouvant être gravé localement pour dégager les plots. Il peut être également un polymère photosensible dont la gravure est de préférence réalisée par insolation directe du polymère.

L'invention porte également sur un module hybride de constitution nouvelle, dont la caractéristique est qu'il comporte plusieurs puces juxtaposées ayant toutes une face active collée sur un même film plan de polymère, avec des interconnexions entre puces réalisées sur ce film et contactant la face active des puces à travers le film.

Ce type de procédé permet de réaliser des connexions de dimensions voisines de celles des circuits inscrits dans les puces, dont l'impédance est parfaitement contrôlée ce qui représente un critère essentiel pour des systèmes fonctionnant à haute fréquence. Il permet de plus l'assemblage de circuits très différents (puces de dimensions différentes, puces d'AsGa et puces de silicium, composants passifs, etc ....) contrairement au procédé utilisant un substrat de silicium dans lequel sont inscrits des circuits.

La présente invention sera mieux comprise et d'autres avantages apparaîtront à la lecture de la description qui va suivre donnée à titre d'exemple non limitatif et grâce aux figures annexées parmi lesquelles :

– la figure 1 représente une puce connectée à une carte selon l'art antérieur ;

– la figure 2 représente un exemple de réalisation d'assemblage de puces par l'intermédiaire d'un film de polymère thermostable, les intercornnexions n'étant pas encore réalisées ;

– la figure 3 illustre un exemple de réalisation de puces assemblées par l'intermédiaire d'un film de polymères thermostables, les interconnexions reliant les plots étant réalisées au-dessus du film de polymère ;

– la figure 4 illustre un module selon l'invention connecté à une carte, le cadre du film ayant être retiré ;

– la figure 5 montre un exemple d'assemblage en trois dimensions de plusieurs modules de puces, obtenus selon le procédé de l'invention, associés par des films de polymère.

Dans la présente invention on ne colle pas les circuits sur un substrat d'interconnexions, mais on colle ces circuits sous un film (F) de polymère. Pour assurer une bonne planéité du film, le polymère peut être tendu par collage ou fixation mécanique sur un cadre rigide. Ce cadre est de préférence en un matériau possédant un coefficient de dilatation proche de celui de polymères thermostables employés. Ainsi il peut s'agir d'un cadre en aluminium qui permet de conserver tout au long des opérations d'interconnexions un état de tension du film constant. De façon préférentielle, ce cadre est circulaire, de diamètre standard et pourvu d'un méplat de positionnement, rendant l'assemblage des puces compatibles avec des équipements standards de la microélectronique utilisée dans les étapes d'interconnexions.

Pour réaliser les interconnexions entre les éléments actifs il est nécessaire de prépositionner ces éléments entre eux. Pour cela, les différentes puces peuvent être prépositionnées sur un support autorisant un degré de liberté en hauteur, leur surface active étant dirigée vers le haut. Ce support doit permettre de maintenir latéralement leurs positions.

On peut alors venir appliquer et coller le film (F) de polymère tendu sur son cadre (C). La tension du film (F) et la souplesse du support permettent la mise des faces supérieures des éléments à assembler dans un même plan, ce qui est nécessaire aux étapes suivantes. Le collage du film (F) sur la surface des éléments à assembler peut être effectué sous vide et obtenu à l'aide d'un adhésif appliqué à l'interface ou par simple application de la température et de la pression dans le cas d'un polymère lui-même adhésif (par exemple un polymère thermoplastique ). Par exemple, les polyetherimides sont capables de fondre et donc d'adhérer à des températures inférieures à leur température de dégradation.

Le film ainsi collé aux éléments actifs sert à la fois pour l'assemblage mécanique des éléments et de diélectrique sur lequel seront réalisées les interconnexions électriques. La figure 2 illustre cette première phase du procédé permettant d'obtenir des puces assemblées par l'intermédiaire d'un polymère tendu grâce à son cadre.

Dans une seconde phase du procédé, les faces actives des puces situées dans un plan unique, plan du film (F) peuvent être interconnectées. L'assemblage film et puces présente l'intérêt de pouvoir être traité de la même manière qu'un substrat semiconducteur monolithique comme par exemple une tranche de silicium ou d'arséniure de gallium. En particulier sa tenue mécanique et la planéité de sa face supérieure permettent les étapes classiques de la fabrication de circuits intégrés que sont le dépôt par centrifugation à la tournette d'une résine photosensible, ou le dépôt sois vide d'une couche mince métallique ou diélectrique, les procédés de photolithographie ou bien encore la gravure assistée par plasma.

Pour réaliser ces interconnexions, les contacts électriques (CE) des différents éléments à connecter sont d'abord dégagés en gravant la couche de polymère (F). Cette gravure est préférentiellement effectuée par gravure ionique réactive du polymère réalisée au travers d'un masque défini par photolithographie. Elle peut être également effectuée par insolation directe à travers un masque si le polymère est photosensible. Il existe en effet des polyimides photosensibles pouvant ainsi être gravés directement.

Elle peut également être effectuée par photoablation. En effet, la photoablation est une technique de gravure efficace dans le cas des polymères.

Lorsque les plots des éléments ont été dégagés, le réseau d'interconnexions électriques (R) peut être réalisé par les techniques connues de l'homme de l'art (métallisation sous vide, dépôts chimiques ou électrochimiques de conducteurs, photogravure). Selon la complexité du réseau d'interconnexions désiré, il est possible de déposer plusieurs niveaux de réseaux conducteurs et de couches d'isolation. L'assemblage ainsi réalisé et interconnecté est illustré par la figure 3 dans le cas d'un seul niveau d'interconnexion.

Ce type de module électronique comportant plusieurs puces interconnectées peut alors être associé aux éléments classiques utilisés en électronique : fixation de l'assemblage sur un boîtier pour favoriser l'échange thermique et renforcer la tenue mécanique de l'ensemble. On peut également envisager la mise en boîtier hermétique ou le dépôt d'une couche de passivation pour assurer une bonne protection vis-à-vis de l'environnement.

Pour cela le cadre du film peut être supprimé par découpe de celui-ci. La figure 4 illustre un exemple de module mis en boîtier et relié à une carte équipée de broches de connexion.

Dans ce type d'assemblage, on dispose d'un plan de base rigide que représente le film de polymère, ce plan de base peut ainsi permettre la superposition de plsieurs modules comme l'illustre la figure 5. Ces assemblages pouvant être connectés les uns aux autres, permettent de réaliser un assemblage total susceptible d'être très dense et ce en trois dimensions.

On notera que le module hybride peut comprendre d'autres composants que des puces de circuit intégré, fixés et interconnectés de la m^eme manière que les puces. Ces composants peuvent être des composants passifs (résistances, capacités) ou encore des éléments qui ne sont pas à proprement parler des composants électroniques mais comportant des fonctions d'interconnection, comme par exemple des croisements ou des distributions réalisés par multicouches minces sur silicium et permettant de simplifier le réseau d'interconnexions réalisé au-dessus du film.

## Revendications

1. Procédé de réalisation d'un module hybride comportant une pluralité de puces de circuits intégrés caractérisé en ce qu'il comprend :
   – la fixation d'un film plan tendu (F) de polymère de bonne tenue mécanique, sur les faces actives de plusieurs puces juxtaposées (la face active étant la face comprenant les plots de contact) ;
   – puis les interconnexions entre puces réalisées par gravure du film de façon à dégager les plots des puces, cette gravure étant suivie d'un dépôt conducteur sur la surface du film et sur les flancs des ouvertures réalisées par gravure.

2. Procédé selon la revendication 1, caractérisé en ce que le film est tendu sur un cadre rigide circulaire de diamètre standard rendant l'assemblage des puces compatible avec les équipements standards de la microélectronique.

3. Procédé selon l'une des revendications 1 à 2, caractérisé en ce que le polymère constituant le film est un polymère thermostable de type polyimide ou polyquinoxaline.

4. Procédé selon la revendication 1, caractérisé en ce que la gravure du film est effectuée par gravure ionique réactive à travers un masque défini par photolithographie.

5. Procédé selon la revendication 1, caractérisé en ce que la gravure est réalisée par photoablation.

6. Procédé selon la revendication 1, caractérisé en ce que le polymère est un polymère photosensible et que la gravure est réalisée par insolation directe du polymère.

7. Procédé selon l'une des revendications 1 à 6, caractérisé en ce que le collage du film sur la surface active des puces est obtenu par un adhésif appliqué à l'interface.

8. Procédé selon l'une des revendications 1 à 6, caractérisé en ce que le polymère est un polymère thermoplastique et que le collage du film sur la surface active des puces est obtenu par une application de la température et de la pression.

9. Procédé selon l'une des revendications 1 à 8, caractérisé en ce que les interconnexions sont réalisées sur le film plan de polymère par dépôt de couches minces et photolithographie.

10. Module hybride comprenant plusieurs puces de circuit intégré interconnectées, caractérisé en ce qu'il comporte plusieurs puces juxtaposées ayant toutes une face active collée sur un même film plan de polymère, avec des interconnexions entre puces réalisées sur ce film et contactant la face active des puces à travers le film.

puce

cablage filaire

carte

# FIG.1

(F)

(C)

puces

# FIG.2

(R)

(F)

(CE)

puces

# FIG.3

(F)

puces

# FIG.4

(F)

(F)

puces

# FIG.5

**Office européen des brevets**

# RAPPORT DE RECHERCHE EUROPEENNE

Numero de la demande

EP 92 40 0751

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| X | DE-A-2 810 054 (MATSUSHITA ELECTRIC IND. LTD.) <br> * page 17, dernier alinéa - page 25, alinéa 3; revendications; figures 4-10 * <br> --- | 1-4,7-10 | H01L23/538 |
| A | US-A-4 783 695 (GENERAL ELECTRIC COMPANY) <br> --- | | |
| A | FR-A-2 599 893 (RICOH CO. LTD.) <br> ----- | | |

**DOMAINES TECHNIQUES RECHERCHES (Int. Cl.5)**

H01L

Le présent rapport a été établi pour toutes les revendications

| Lieu de la recherche | Date d'achèvement de la recherche | Examinateur |
|---|---|---|
| LA HAYE | 25 MAI 1992 | PROHASKA G.A. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

                                     
& : membre de la même famille, document correspondant

EPO FORM 1503 03.82 (P0402)